# EUROPEAN PATENT APPLICATION

(11) **EP 0 701 394 A1**
(43) Date of publication of application: **13.03.1996**
(21) Application number: 95305999.5
(22) Date of filing: 29.08.1995
(51) Int. Cl.: H05K 13/08, H05K 13/02

(54) **Component mounting apparatus**

(30) Priority: 06.09.1994 JP 212657/94
(71) Applicant: KABUSHIKI KAISHA TOSHIBA, Kawasaki-shi, Kanagawa-ken 210, Tokyo (JP); Japan Tobacco Inc., Minato-Ku Tokyo 105 (JP)
(72) Inventor: Sano, Katsuya, c/o Mie Works K.K. Toshiba, Mie-gun, Mie-ken (JP); Kobayashi, Kazutaka, c/o Japan Tobacco Inc., Tokyo (JP)
(74) Representative: Freed, Arthur Woolf

(57) **Abstract**

A component mounting apparatus includes a rotating drum (13), a plurality of mounting heads (24) having respective suction nozzles (26), a plurality of component feeders (18), and a drive mechanism for moving one of the mounting heads (24) to an obtaining location (A) where the mounting head (24) obtains an electronic component (16) to be mounted on a printed circuit board (20). In the selection of the mounting head (24) to be moved to the obtaining location (a), a control device composed of a microcomputer obtains, by calculation, time t₁ the component feeder (18) designated by instruction data has been moved to the obtaining location (a) and time t₂ the mounting head (24) has been moved to the obtaining location (b). When the control device determines that time t₁ occurs before time t₂, the designated component feeder (18) is selected. On the other hand, when determining that time t₁ occurs after time t₂, the control device searches all the component feeders (18) loaded with the same type of components (16) and selects the component feeder (18) loaded with the component (16) which can be mounted earliest.

## Description

This invention relates to a component mounting apparatus comprising mounting heads which are supplied with components such as electronic components at a feed station and carry the components to a mounting station to thereby mount the components to an object such as a printed circuit board.

Component mounting apparatus employing a continuous rotation cycloid system have been developed for automatically mounting components such as electronic components to an object such as a printed circuit board. The apparatus comprises a plurality of mounting heads which are provided on an outer circumference of a rotating drum and which can provide a high-speed component mounting operation.

FIG. 5 schematically illustrates one of such conventional component mounting apparatus. The shown apparatus comprises a rotating drum 1 continuously rotated in a direction of arrow A by an electric motor and for example, twelve mounting heads 2 provided on the outer circumference of the rotating drum 1. Each mounting head 2 includes a suction nozzle (not shown) provided on a lower end thereof for sucking a component. Each mounting head 2 is turned about an axis extending radially of the drum 1 in synchronism with rotation of the drum 1 with a tip of the suction nozzle directed downwardly.

A feed station 3 is provided in the vicinity of the outer circumference of the rotating drum 1 for the purpose of feeding components to the mounting heads 2. A mounting station 4 is provided in the vicinity of the outer circumference of the drum 1 so as to be opposite to the feed station 3. The feed station 3 includes a base, a plurality of component feeders 5 arranged transversely on the base, and a moving mechanism for moving the base in the directions of arrow B. The mounting station 4 includes, for example, an X-Y table for moving the circuit board to an optional location. The suction nozzle of each mounting head 2 performs a cycloid movement around the drum 1. The cycloid movement has, for example, ten bottom dead points. The rotational speed of the drum 1 and the turning speed of each mounting head 2 are denied by each other at each bottom dead point, so that a ground speed of each suction nozzle is reduced to zero. According to sucking and mounting instruction data, each mounting head 2 obtains, by means of suction, a component at one of the bottom dead points located over the feed station 3 (an obtaining location a, and mounts the component to a predetermined mounting point of the circuit board at one of the other bottom dead points located over the mounting station 4 (a mounting location b). This operation is repeated continuously by the twelve mounting heads 2, whereupon high-speed mounting work can be achieved.

In order that each suction nozzle of the mounting head 2 sucks the component at the obtaining location a, the component feeder 5 corresponding to the type of the component currently required needs to be located at the obtaining location a. Accordingly, upon completion of the component obtaining operation by the previous mounting head 2, the component feeder which is loaded with a component to be obtained by the subsequent mounting head 2 is moved to the obtaining location a by the moving mechanism. In such a case, which of the component feeders 5 should be moved to the obtaining location a is previously determined in the sucking and mounting instruction data. This is also the case where a plurality of component feeders loaded with the same type of components are set on the base.

The movement of the component feeder 5 to the obtaining location a is sometimes completed before the time of arrival of the mounting head 2 at the obtaining location a when there is a relatively long distance between the component feeder 5 currently located at the obtaining location a and the subsequent component feeder 5 to be subsequently moved to the obtaining location a, that is, when the distance of movement of the component feeder 5 is rendered long. One or more of the mounting heads 2 are skipped over when the movement of the subsequent component feeder 5 is not in time for the component sucking operation of the mounting head 2 as described above. However, this retards the times the components are mounted by the respective skipped mounting heads 2, which results in reduction of the component mounting efficiency.

The prior art has provided another type of component mounting apparatus, wherein each of the mounting heads 2 provided on the outer circumference of the rotating drum 1 does not perform the cycloid movement but is stopped over the obtaining location a and is subsequently lowered to obtain the component. In this type, too, when the movement of the component feeder is out of time, a time period of stop of the mounting heads 2 is rendered long. This also retards the times the components are mounted by the respective skipped mounting heads 2, which results in reduction of the component mounting efficiency.

Therefore, an object of the present invention is to provide a component mounting apparatus wherein the number of or the period of the skipped component obtaining operations of the mounting heads can be reduced, or the period of interrupt of the mounting heads can be reduced so that the component mounting efficiency can be improved.

To achieve the object, the present invention provides a component mounting apparatus comprising a feed station provided with a plurality of component feeders, and a mounting head moved between a predetermined obtaining location on the feed station and a mounting location where an object to which a component is to be mounted is disposed, the mounting head being moved to the obtaining location to obtain a component from the previously designated one of the component feeders, the mounting head being subsequently moved to the mounting location to mount the component to the object, characterized by determining means provided for determining as to whether or not a time t₁ when the component is fed by the previously designated component feeder to the obtaining location, occurs before a time t₂ when the mounting head has been moved to the obtaining location to obtain the component, and component feeder selecting means is provided for selecting, prior to the designated component feeder, one of all the component feeders loaded with the same type of components when the determining means determines that the time t₁ lags behind the time t₂, said one component feeder being so located that the component loaded thereon can be mounted earliest.

According to the above-described construction, the determining means determines as to whether or not the component can be fed from the previously designated component feeder to the obtaining location until time t₂ when the mounting head has been moved to the obtaining location to be able to obtain the component. The operation of the mounting head for obtaining the component is not skipped nor interrupted when time t₁ occurs before time t₂. On the other hand, when the determining means determines that time t₁ lags behind time t₂, the component feeder selecting means selects one of all the component feeders that are loaded with the same type of components, the one component feeder being so located that the component loaded thereon can be mounted earliest. Consequently, the number of skipped component obtaining operations can be reduced to zero or to the minimum, which can restrict the reduction in the component mounting efficiency to the minimum.

In a preferred form, the component feeders are moved in a designated order to the obtaining location to feed the components.

In another preferred form, a plurality of the obtaining locations are provided along a movement path of the mounting head so as to correspond to the component feeders, and further comprising a plurality of the mounting heads, and means for selecting one of the mounting heads at the obtaining location corresponding to the component feeder selected by the component feeder selecting means.

The invention will be described, merely by way of example, with reference to the accompanying drawings, in which:
FIG. 1 is a flowchart showing the procedure for selecting a component feeder in a component mounting apparatus of a first embodiment in accordance with the present invention;
FIG. 2 is a schematic plan view of the component mounting apparatus;
FIG. 3 is a schematic perspective view of a rotating drum and one of mounting heads;
FIG. 4 is a schematic plan view of the rotating drum and the mounting heads provided in the component mounting apparatus of a second embodiment in accordance with the present invention; and
FIG. 5 is a schematic plan view of a rotating drum and mounting heads of a prior art component mounting apparatus.

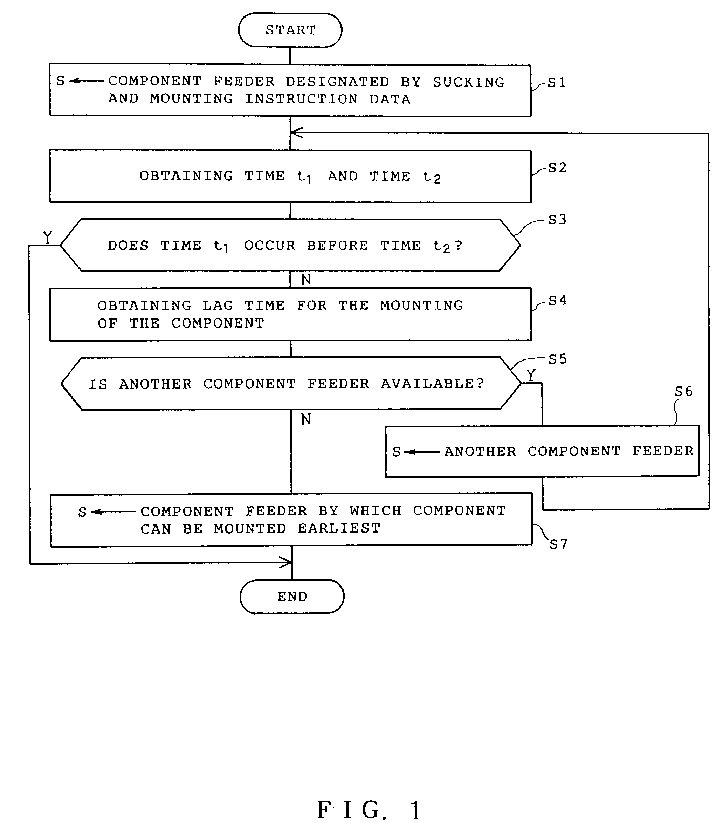

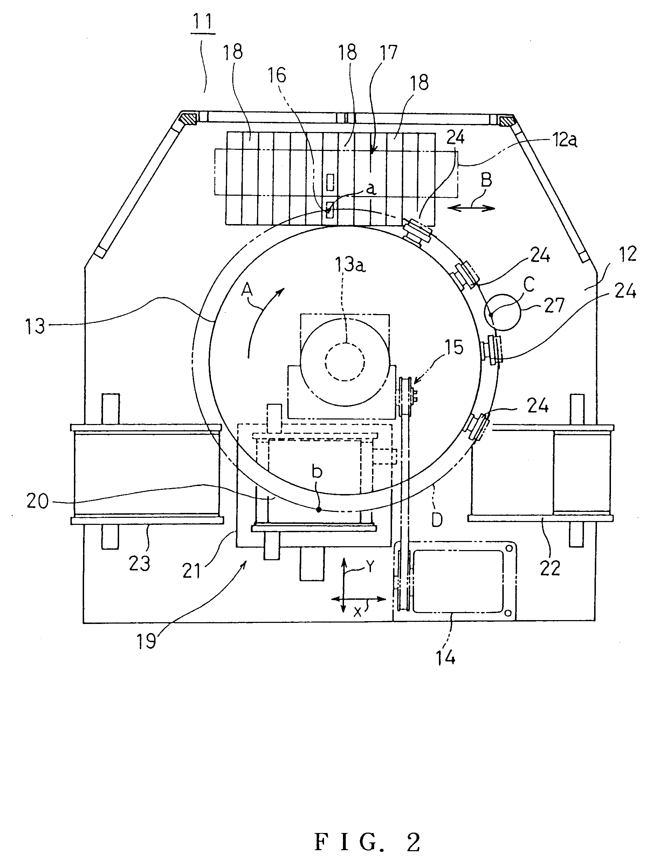

A first embodiment of the present invention will be described with reference to FIGS. 1 to 3. Referring first to FIG. 2, a component mounting apparatus in accordance with the present invention is shown. The apparatus comprises a main body 11 having a base 12. A rotating drum 13 is provided on a central portion of the base 12. The rotating drum 13 includes a drive motor 14 such as an AC servomotor and a reduction gear mechanism 15. The rotating drum 13 is rotated continuously at a constant speed in a direction of arrow A about a shaft 13a.

A feed station 17 is provided at the rear of the rotating drum 13 on the base 12. The feed station 17 supplies electronic components 16 such as chips to mounting heads as will be described in detail later. The feed station 17 includes a mounting base 12a extending transversely, that is, in the direction of X-axis and a plurality of component feeders 18 such as tape feeders mounted transversely in a row on the mounting base 12a. Each component feeder 18 holds a number of electronic components 16 taped on a long tape and feeds the electronic components 16 one by one to a component supply point at the forward end thereof. The component feeders 18 thus mounted on the mounting base 12a include those accommodating the same type of electronic components. The mounting base 12a is moved transversely, that is, in the directions of arrow B by a drive mechanism (not shown) so that one component feeder 18 (the component supply point) is selectively moved to an obtaining location a.

A mounting station 19 is provided in front of the rotating drum 13 on the base 12. The mounting station 19 includes an X-Y table 21 on which a printed circuit board 20 serving as an object to which the electronic components 16 are to be mounted is set. The X-Y table 21 is movable horizontally, that is, in the X-axis and Y-axis directions, so that one of component mounting points on the printed circuit board 20 is moved to a mounting location b. Feed-in and take-out conveyers 22 and 23 are provided for carrying the printed circuit board 20 onto and out of the X-Y table 21 respectively.

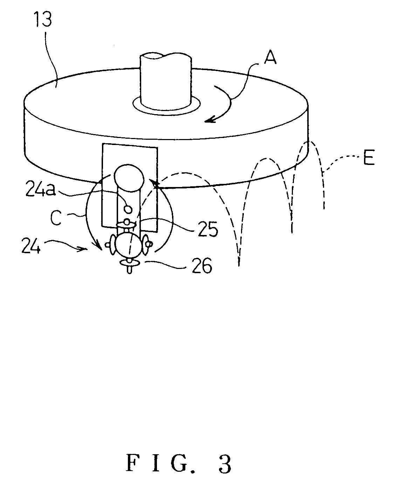

A plurality of mounting heads 24 (twelve in the embodiment) are mounted on the outer circumference of the rotating drum so as to be arranged circumferentially at equal intervals. Each mounting head 24 includes a link 25 and a suction nozzle 25 mounted on one end of the link 25 and is provided for sucking the electronic component 16, as shown in FIG. 3. The suction nozzle 26 is turned about a shaft 24a extending radially of the rotating drum 13. The suction nozzles 26 are connected to a pneumatic pressure adjusting source (not shown).

Each mounting head 24 is turned counterclockwise, that is, in the direction of arrow C (rotation) by a power transmission mechanism (not shown) provided in the rotating drum 13 in synchronism with rotation of the drum 13 in the direction of arrow A (revolution). A tip of each suction nozzle 26 is directed downwardly by an attitude maintaining mechanism (not shown) while the mounting head 24 is being rotated. Consequently, each suction nozzle 26 performs a cycloid movement having a trajectory as shown by broken line E in FIG. 3 along the outer circumference of the drum 13. A ratio of the revolution diameter and the rotation diameter of each suction nozzle 26 is set at 10:1, for example, and a ratio of the revolving speed and the rotational speed of each suction nozzle 26 is set at 1:10. Consequently, each suction nozzle 26 performs a cycloid movement fixedly having ten bottom dead points around the rotating drum 13.

The rotational speed of the rotating drum 13 and the turning speed of the mounting head 24 are denied by each other at each bottom dead point, whereupon the ground speeds of the suction nozzle 26 in the horizontal and vertical directions with respect to the base 12 become zero. The above-described obtaining and mounting locations a and b are set at predetermined bottom dead points respectively. Consequently, each mounting head 24 (each suction nozzle 26) obtains the electronic component 16 of the predetermined type by means of suction making use of negative gaseous pressure at the obtaining location a corresponding to the predetermined bottom dead point over the feed station 17. Furthermore, each mounting head 24 mounts the electronic component 16 to the printed circuit board 20 by release from the negative pressure condition at the mounting location b corresponding to the predetermined bottom dead point over the mounting station 19. These operations are performed alternately continuously.

A monitoring device comprising a CCD camera 27 is provided for checking that the suction nozzle 26 properly sucks the electronic component 16, at one of the bottom dead points between the obtaining location a and the mounting location b, as shown in FIG. 2.

The mechanisms constructed as described above are controlled by a control device (not shown) comprising a microcomputer. The control device incorporates sucking and mounting instruction data for instructing coordinates of the component mounting point on the printed circuit board 20, the type of the component to be mounted, the mounting order, and the like, so that the component mounting work by the mounting heads 24 is executed. The sucking and mounting instruction data previously designates one or more of the component feeders 18 to be selected for obtainment of the components 16.

In continuous feed of the components 16 at the obtaining location a of the feed station 17, a distance between the component feeder 18 currently located at the obtaining location a and the component feeder 18 which is to be subsequently moved to the obtaining location a is sometimes relatively long, that is, the component feeder 18 needs to be moved a relatively long distance. In such a case, the completion of movement of the component feeder 18 to the obtaining location a lags behind the time the mounting head 24 (the suction nozzle 26) reaches the obtaining location a.

In view of the foregoing problem, the control device previously stores component type data about the locations of the component feeders 18 set on the mounting base 12a and about the types of the components 16 loaded on the component feeders 18. Furthermore, the control device incorporates a software arrangement to determine as to whether or not the predetermined component feeder 18 can feed the component 16 to the obtaining location a before the time the mounting head 24 is moved to the obtaining location a to be capable of obtaining the component 16.

The control device determines as to whether or not time t₁ the component feeder 18 previously designated by the sucking and mounting instruction data can feed the component 16 lags behind time t₂ the mounting head 24 can obtain the component 16. When determining that time t₁ lags behind time t₂, the control device further determines as to whether or not another component feeder 18 loaded with the same type of components can reach the obtaining location a before time t₂. When determining that another component feeder 18 loaded with the same type of components can reach the obtaining location a before time t₂, the control device controls the feed station 17 so that said another component feeder 18 is selected. When determining that all the component feeders 18 loaded with the same type of components lag behind time t₂, the control device controls the feed station 17 to select one of the component feeders 18 loaded with the component 16 which can be mounted to the printed circuit board 20 earliest. The control device thus functions as determining means and component feeder selecting means in the present invention.

The operation of the component mounting apparatus will be described. FIG. 1 shows a procedure for selecting the component feeder 18 to be moved to the obtaining location a when the component mounting work is performed by means of the mounting heads 24. The component feeder 18 previously designated by the sucking and mounting instruction data is substituted for a variable S indicative of the component feeder 18 to be selected, at step S1. Then, the control device obtains, by calculation, time t₁ when the component feeder 18 indicated by variable S has been moved to the obtaining location a to be able to feed the component, at step S2. The control device further obtains time t₂ when the mounting head 24 has been moved to the obtaining location a to thereby obtain the component 16, at step S2. The control device determines at step S3 as to whether or not time t₁ obtained occurs before time t₂ obtained. When the control device determines that time t₁ occurs before time t₂, the component feeder 18 indicated by variable S is selected.

On the other hand, when determining at step S3 that time t₁ occurs after time t₂, the control device advances to step S4 to obtain and store a lag time between the time the component 16 is mounted to the printed circuit board 20 by the use of the component feeder 18 designated by the sucking and mounting instruction data and the current mounting head 24 and the time the component 16 is mounted to the printed circuit board 20 by use of the designated component feeder 18 and the mounting head 24 subsequent to the current one, which is skipped over. In this regard, the mounting head 24 located nearest the obtaining location a, in other words, the mounting head 24 loaded with the component 16 which can be mounted earliest is selected.

The control device determines at step S5 as to whether or not another component feeder 18 loaded with the same type of components 16 is present. When determining that another component feeder 18 loaded with the same type of component 16 is present, the control device advances to step S6 where said another feeder 18 is substituted for variable S, then repeating steps S2-S6. Thus, the component feeder 18 which can feed the component to the obtaining location a before the mounting head 24 arrives at the obtaining location a is searched. When such a component feeder 18 is present, it is selected in preference to the component feeder 18 designated by the sucking and mounting instruction data.

Now, assume the case where none of the component feeders 18 loaded with the same type of components 16 can reach the obtaining location a before time t₂. In such a case, the control device determines in the negative at step S5, advancing to step S7. As the result of repeated processing of steps S2-S6, the control device stores data of the lag time obtained as described above with respect to the component feeders 18 loaded with the same type of components 16. Based on the data of the lag time, the control device selects the component feeder 18 loaded with the component 16 which can be mounted earliest. As described above, even when the movement of the component feeder 18 designated by the sucking and mounting instruction data is not in time for the obtaining of the component 16 by the mounting head 24, one of the component feeders 18 loaded with the same type of components 16 is selected, said one component feeder 18 being in time for the obtaining of the component 16 by the mounting head 24 or being loaded with the component 16 which can be mounted earliest. Consequently, reduction in the efficiency of the component mounting work can be restricted to the minimum.

According to the foregoing embodiment, the control device determines as to whether or not the feeding of the component 16 by the previously designated component feeder 18 is in time for the obtaining of the component 16 by the mounting head 24. When the result of determination is negative, one of the component feeders 18 loaded with the same type of components 16 is selected in preference to that designated by the sucking and mounting instruction data. Furthermore, when none of the component feeders 18 loaded with the same type of components 16 are in time for the obtaining of the component 16 by the mounting head 24, the component feeder 18 loaded with the component 16 which can be mounted on the printed circuit board 20 earliest is selected in preference to that designated by the sucking and mounting instruction data. Thus, differing from the prior art apparatus in which the order of selection of the component feeders is fixedly determined by the sucking and mounting instruction data, the above-described component mounting apparatus can improve the efficiency of the component mounting work.

A plurality of mounting heads 24 are provided so as to be continuously moved along the same path. One of the mounting heads 24 is so selected that the component 16 can be mounted onto the printed circuit board 20 earliest. Consequently, further improvement in the efficiency of the component mounting work can be achieved. Furthermore, the suction nozzles 26 are mounted on the respective mounting heads 24 so as to each perform the cycloid movement. The obtaining location a and the mounting location b are set at two of the bottom dead points of the cycloid movement respectively. Consequently, high-speed mounting work can be realized.

The above-described step S3 includes the processing for searching and selecting another component feeder 18 which can feed the component 16 in time for the obtaining of the component 16 by the mounting head 24. This processing is included in a concept of the processing for selecting the component feeder 18 so located that the component 16 thereof can be mounted earliest.

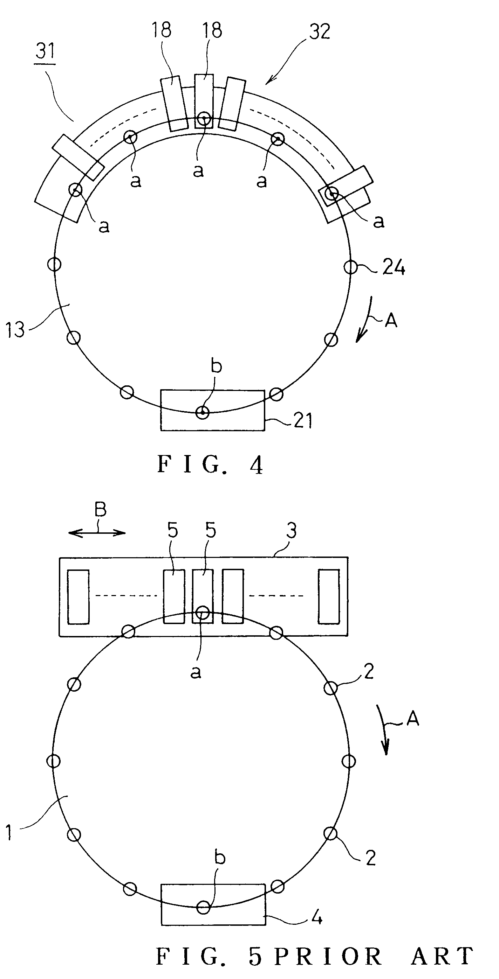

FIG. 4 schematically illustrates a base 31 of the component mounting apparatus of a second embodiment in accordance with the present invention. The second embodiment differs from the foregoing embodiment mainly in the construction of the feed station 32. More specifically, the feed station 32 is located in the rear of the rotating drum 13 and is formed into the shape of an arc so that it extends along the outer circumference of the rotating drum 13. A number of component feeders 18 including those loaded with the same type of components are provided on the feed station 32 so as to arrange circumferentially along the movement trajectory D of a plurality of mounting heads 24 (suction nozzles 26).

Each mounting head 24 is turned about an axis extending radially of the drum 13 by the drive source which is discrete from that driving the drum 13. Accordingly, since each mounting head 24 can be set at any rotational speed, the bottom dead points can be placed at any points on the movement trajectory D such that each mounting head 24 can obtain the component 16 and mount it onto the printed circuit board 20 at the points respectively. Consequently, a plurality of obtaining locations a corresponding to a plurality of component feeders 18 respectively are present along the path of movement of the component feeders 18.

Since each component feeder 18 is not moved in the embodiment, a period for the movement is not required. However, when a plurality of the same type components 16 are continuously fed to the mounting heads 24, some period is required when one component 16 has been taken out of the component feeder 18 and then, a subsequent one is fed from the same component feeder 18 to the obtaining location a. Accordingly, when the components 16 are continuously fed from one and the same component feeder 18, a period of feeding the component 16 is sometimes longer than a period required for the mounting head 24 to obtain the component 16.

The processing for selecting the component feeder 18 in the second embodiment is substantially the same as shown in FIG. 1 with one exception, wherein time t₁' is obtained as a time when the component 16 within the component feeder 18 can be fed to the obtaining location a, instead of time t₁. In other words, in selection of the component feeder 18, the control device also searches the component feeders 18 loaded with the same type of components 16 and selects the component feeder 18 loaded with the component 16 which can be mounted on the printed circuit board 20 earliest, as in the first embodiment. Furthermore, the mounting head 24 is so selected that it can obtain the component at the obtaining location a which corresponds to the selected component feeder 18. Since the component feeders 18 need not be moved in the second embodiment, a high-speed component mounting work can be ensured.

The feed station may be formed into the shape of an arc and may be movable. The rotating drum may be interrupted when the mounting head 24 obtains the component 16 and when the component 16 is mounted onto the printed circuit board 20, instead of being continuously rotated. An X-Y robot or the like may be employed for moving the mounting heads 24, instead of the rotating drum 13. Stick feeders or trays may be employed as the component feeders provided on the feed station, instead of the tape feeders.

## Claims

1. A component mounting apparatus comprising a feed station (17) provided with a plurality of component feeders (18), and a mounting head (24) moved between a predetermined obtaining location (a) on the feed station (17) and a mounting location (b) where an object (20) to which a component (16) is to be mounted is disposed, the mounting head (24) being moved to the obtaining location (a) to obtain a component (16) from the previously designated one of the component feeders (18), the mounting head (24) being subsequently moved to the mounting location (b) to mount the component (16) to the object (20), characterized by determining means for determining as to whether or not a time t₁ when the component (16) is fed by the previously designated component feeder (18) to the obtaining location (a), occurs before a time t₂ when the mounting head (24) has been moved to the obtaining location (a) to obtain the component (16), and component feeder selecting means for selecting, prior to the designated component feeder (18), one of all the component feeders (18) loaded with the same type of components (16) when the determining means determines that the time t₁ lags behind the time t₂, said one component feeder (18) being so located that the component (16) loaded thereon can be mounted earliest.

2. A component mounting apparatus according to claim 1, characterized in that a plurality of the mounting heads (24) are provided so as to be moved continuously along one and the same movement path, and further characterized by means for selecting one of the mounting heads (24) which is so located that the component (16) loaded thereon can be mounted earliest, so that said one mounting head (24) can obtain the component (16).

3. A component mounting apparatus according to claim 1, characterized in that the component feeders (18) are moved in a designated order to the obtaining location (a) to feed the components (16).

4. A component mounting apparatus according to claim 1, characterized in that a plurality of the obtaining locations (a) are provided along a movement path of the mounting head (24) so as to correspond to the component feeders (18), and further characterized by a plurality of the mounting heads (24), and means for selecting one of the mounting heads (24) so that said one mounting head (24) can obtain the component (16) at the obtaining location (a) corresponding to the component feeder (18) selected by the component feeder selecting means.

5. A component mounting apparatus according to claim 1, further characterized by a rotating drum (13) rotated by a drive source (14), and characterized in that the obtaining location (a) and the mounting location (b) are provided around the rotating drum (13), in that the mounting head (24) is mounted on the rotating drum (13) so as to be turned about an axis extending radially of the drum (13) and so as to perform a cycloid movement, and in that the obtaining and mounting locations (a, b) are set at bottom dead points of the cycloid movement respectively.

6. A component mounting apparatus according to claim 3, further characterized by a rotating drum (13) rotated by a drive source (14), and characterized in that the obtaining location (a) and the mounting location (b) are provided around the rotating drum (13), in that the mounting head (24) is mounted on the rotating drum (13) so as to be turned about an axis extending radially of the drum (13) and so as to perform a cycloid movement, and in that the obtaining and mounting locations (a, b) are set at bottom dead points of the cycloid movement respectively.

7. A component mounting apparatus according to claim 4, further characterized by a rotating drum (13) rotated by a drive source (14), and characterized in that the obtaining location (a) and the mounting location (b) are provided around the rotating drum (13), in that the mounting head (24) is mounted on the rotating drum (13) so as to be turned about an axis extending radially of the drum (13) and so as to perform a cycloid movement, and in that the obtaining and mounting locations (a, b) are set at bottom dead points of the cycloid movement respectively.
